# EUROPEAN PATENT APPLICATION

(11) **EP 2 452 774 A1**
(43) Date of publication of application: **16.05.2012**
(21) Application number: 09847108.9
(22) Date of filing: 07.10.2009
(51) Int. Cl.: B23K 26/14, B23K 26/08, B23K 26/10, B23K 26/36, B23K 26/00

(54) **LASER CUTTING MACHINE**

(30) Priority: 07.07.2009 JP 2009160442
(71) Applicant: Kataoka Corporation, Kyoto-shi Kyoto 601-8203 (JP)
(72) Inventor: MATSUMOTO, Junichi, Kyoto-shi Kyoto 601-8203 (JP); NISHI, Norio, Kyoto-shi Kyoto 601-8203 (JP); TAKEDA, Nobuyuki, Kyoto-shi Kyoto 601-8203 (JP); YAMAGISHI, Norihiro, Kyoto-shi Kyoto 601-8203 (JP); SUZUKI, Masami, Kyoto-shi Kyoto 601-8203 (JP)
(74) Representative: TBK
(86) International application number: PCT/JP2009/067453
(87) International publication number: WO 2011/004509

(57) **Abstract**

A laser beam machine 1 includes retention mechanisms 2 for retaining a substrate 9 not to be moved with a processed surface up, processing nozzles 3 for traveling in the Y axis direction and emitting a laser beam to the processed surface of the substrate 9, the processing nozzles 3 being also movable in the X axis direction, a dust collection nozzle 5 for traveling in the Y axis direction following travel of the processing nozzles 3, and a support mechanism 4 relatively movable in the X axis direction relative to this substrate 9 while supporting the substrate 9 from the lower side. In the laser beam machine 1, the substrate 9 is not moved at the time of laser beam machining. While the processing nozzles 3 and the dust collection nozzle 5 travel, the laser beam machining is performed, and powder dust generated from a processed part to which the laser beam is irradiated is suctioned. At the time of pitch-feeding and moving the processing nozzles 3 in the X axis direction, the support mechanism 4 is also moved in the X axis direction, so that contact between the support mechanism 4 and a laser beam axis is avoided.

## Description

### TECHNICAL FIELD

The present invention relates to a laser beam machine for performing laser scribing, patterning, and the like to a thin film in a manufacturing process of for example, a solar panel, an organic EL display, and a plasma display.

### BACKGROUND ART

This type of laser beam machine mainly irradiates a laser beam to a thin film of a single layer or a laminated layer formed on a processed surface of a substrate, so as to perform removal processing. In a laser beam machine already proposed by the applicant (refer to the following Patent Document 1), a substrate is conveyed by a platform truck while being levitated with using a levitation device for blowing out the air, and patterning is performed to a thin film by a laser beam emitted from processing nozzles installed in a predetermined processing region.

The laser beam machine described in the following Patent Document 1 is excellently useful. However, there is a tendency that in order to reciprocate the substrate back and forth in the processing region at the time of laser beam machining, an area which is double or more of substrate size is required.

In addition, the laser beam machine described in the following Patent Document 1 mainly assumes a use method of placing the substrate with the processed surface down, emitting the laser beam down from the upper side of the substrate, making the laser beam pass through the substrate, and irradiating the laser beam to the processed surface. On the other hand, in a CVD (Chemical Vapor Deposition) device, a sputtering device, and the like, a substrate is placed with a processed surface up, and a thin film is formed on the processed surface. Therefore, there is a need for arranging an inversion machine for inverting the substrate between these devices and a laser beam machine. When the substrate conveyed out from the laser beam machine is moved, the substrate is usually carried while being supported from the lower side with the processed surface up in order not to damage the thin film. After all, there is a need for inversion machines installed on both the front and rear sides of the laser beam machine.

Recently, the substrate is gradually enlarged (for example, 2,600 mm × 2,200 mm in G8 class). Thus, it is inevitable that both the laser beam machine and the inversion machine are enlarged more and more. Regarding the inversion machine, even height size is increased. Thus, there is a restriction that the inversion machine cannot be installed unless a ceiling of a factory is high.

### PRIOR ART DOCUMENT

### PATENT DOCUMENT

Patent Document 1: Japanese Patent No. 4231538

### SUMMARY OF THE INVENTION

### PROBLEMS TO BE SOLVED BY THE INVENTION

A major object of the present invention achieved in consideration with the above situations is to eliminate a need for an inversion machine, and to reduce a required area of a laser beam machine itself.

### MEANS FOR SOLVING THE PROBLEMS

In the present invention, a laser beam machine includes a main body supporting a substrate with a processed surface to which laser beam machining is performed up, a processing nozzle provided on the lower side of the substrate so as to travel in the predetermined traveling direction, the processing nozzle for emitting a laser beam upward, making the laser beam pass through the substrate, and irradiating the laser beam to the processed surface, and a dust collection nozzle provided on the upper side of the substrate so as to travel in the traveling direction following the processing nozzle, the dust collection nozzle being always placed immediately above a laser beam irradiation part of the processed surface or the vicinity of the irradiation part, the dust collection nozzle for suctioning powder dust generated from the irradiation part and scattered upward.

With such a machine, there is no need for reciprocating the substrate back and forth at the time of the laser beam machining, so that the required area of the machine can be reduced. Furthermore, the substrate can be conveyed into and out from the laser beam machine while keeping the processed surface up. Thus, there is no need for the inversion machine.

However, in ablation processing of irradiating a laser beam emitted from the lower side to the processed surface on the substrate, powder dust of a cut thin film is evaporatively or explosively scattered. When this powder dust is attached to the processed surface of the substrate again, quality and performance of a product are adversely affected. Therefore, there is a need for arranging the dust collection nozzle for suctioning the powder dust on the upper side of the substrate. However, even when a large-diameter nozzle of a simple shape to cover most part of the substrate is provided, a suction flow rate (or suction pressure) in the vicinity of the laser beam irradiation part where the powder dust is generated cannot be maintained to be high. Thus, dust of large mass cannot be suctioned.

Meanwhile, in the present invention, the dust collection nozzle travels following the processing nozzle. Thus, while narrowing inner size of a suction port of the dust collection nozzle, the suction port is always positioned immediately above or in the vicinity of the laser beam irradiation part during processing. In such a way, the powder dust scattered upward upon receiving irradiation of the laser beam can be quickly collected via the dust collection nozzle, and the suction flow rate in the vicinity of the laser beam irradiation part is effectively increased. Thus, the dust of large mass can be also reliably suctioned.

Preferably, the dust collection nozzle has a downward suction port provided in the vicinity of the processed surface of the substrate and opened immediately above the irradiation part. In addition, preferably, this suction port is formed into a long and thin hole expanding in the direction crossing the traveling direction. The dust collection nozzle travels following the processing nozzle. Thus, the inner size of the suction port along the traveling direction is allowed to be narrowed down.

Further, when lips bent so as to be away from each other protrude from lower ends of front and rear walls forming the suction port and facing in the traveling direction in the dust collection nozzle, an air stream flowing in the direction of the suction port can be generated in a clearance between lower surfaces of these lips and the processed surface of the substrate, so that powder dust suctioning efficiency is remarkably improved.

Alternatively, the dust collection nozzle may have a suction port in the traveling direction provided in the vicinity of the processed surface of the substrate and opened in the vicinity of the irradiation part. In this case as well, preferably, the suction port is formed into a long and thin hole expanding in the direction crossing the traveling direction.

When the laser beam machine further includes a dust collection connection mechanism placed between the dust collection nozzle and a dust collection machine, wherein the dust collection connection mechanism includes a pair of rollers separated along the traveling direction, a chamber arranged between the rollers, the chamber extending along the traveling direction and having an opening expanding in the same direction, a belt looped over the rollers, the belt for closing the opening of the chamber and having a through hole formed in part thereof, and a duct with one end joined to the dust collection nozzle and the other end joined to the through hole, and dust collection is performed via the dust collection nozzle, the duct, and the chamber by connecting the dust collection machine to the chamber, the belt and the through hole thereof can be displaced in conjunction with travel of the dust collection nozzle. Thus, without deformation of the duct connecting the dust collection nozzle and the through hole, the dust collection nozzle can be driven to travel. Thereby, such a disadvantage that the duct is broken due to fatigue caused by reciprocating travel of the dust collection nozzle can be prevented.

When a slipping member for reducing friction with the belt is installed in an opening edge of the chamber, abrasion of the belt and/or the chamber can be suppressed.

When the processing nozzle is also movable in the pitch feed direction crossing the traveling direction, a substantially entire surface of the substrate can be processed through pitch feed of the processing nozzle.

The main body includes a retention mechanism for retaining the substrate not to be moved, and a support mechanism relatively movable in the pitch feed direction relative to the substrate while supporting the substrate from the lower side. In this laser beam machine, the substrate is not moved at the time of the laser beam machining, but the processing nozzle is moved so as to irradiate the laser beam to a desired part of the processed surface. Typically, the processing nozzle travels so as to continuously irradiate a pulse laser beam, and grooves extending along the traveling direction thereof are formed in the thin film. At the time of moving the processing nozzle in the pitch feed direction, the support mechanism is also moved in the pitch feed direction, so that contact between the support mechanism and a laser beam axis is avoided. At this time, the support mechanism is displaced relative to the substrate, and the substrate is still unmoved. In this connection, by applying the pitch feed of the processing nozzle, such processing that the grooves extending along the pitch feed direction are formed in the thin film can be executed.

### EFFECTS OF THE INVENTION

According to the present invention, there is no need for inverting the substrate at the time of conveying the substrate into the laser beam machine and conveying the substrate out from the laser beammachine. Thus, there is no need for the inversion machine. The required area of the laser beam machine itself is reduced as well. Moreover, the powder dust scattered upward from the processed surface receiving irradiation of the laser beam can be quickly collected via the dust collection nozzle, so that a high dust collection effect can be realized.

### BRIEF DESCRIPTION OF THE DRAWINGS

Fig. 1 is an overall perspective view showing a laser beam machine of one embodiment of the present invention.
Fig. 2 is an exploded perspective view showing processing nozzles, a support mechanism, and a dust collection nozzle of the same laser beam machine.
Fig. 3 is an exploded perspective view in which the dust collection nozzle of the same laser beam machine is omitted.
Fig. 4 is a partial perspective view showing the dust collection nozzle and a dust collection connection mechanism of the same laser beam machine.
Fig. 5 is a front view showing the dust collection nozzle of the same laser beam machine.
Fig. 6 is a side view showing the dust collection nozzle of the same laser beam machine.
Fig. 7 is a side sectional view showing the dust collection connection mechanism of the same laser beam machine.
Fig. 8 is a front sectional view showing the dust collection connection mechanism of the same laser beam machine.
Fig. 9 is a partial side sectional view showing a state that a suction port of the dust collection nozzle of the same laser beam machine is positioned immediately above a laser beam irradiation part.
Fig. 10 is a partial perspective view showing one modified example of the present invention.
Fig. 11 is a partial perspective view showing one modified example of the present invention.
Fig. 12 is a partial side sectional view showing the same modified example.
Fig. 13 is a partial side sectional view showing one modified example of the present invention;
Fig. 14 is a partial side sectional view showing one modified example of the present invention.
Fig. 15 is a partial perspective view showing one example of a thin-film solar cell serving as an object to which the laser beam machine according to the present invention is applied.

### MODES FOR CARRYING OUT THE INVENTION

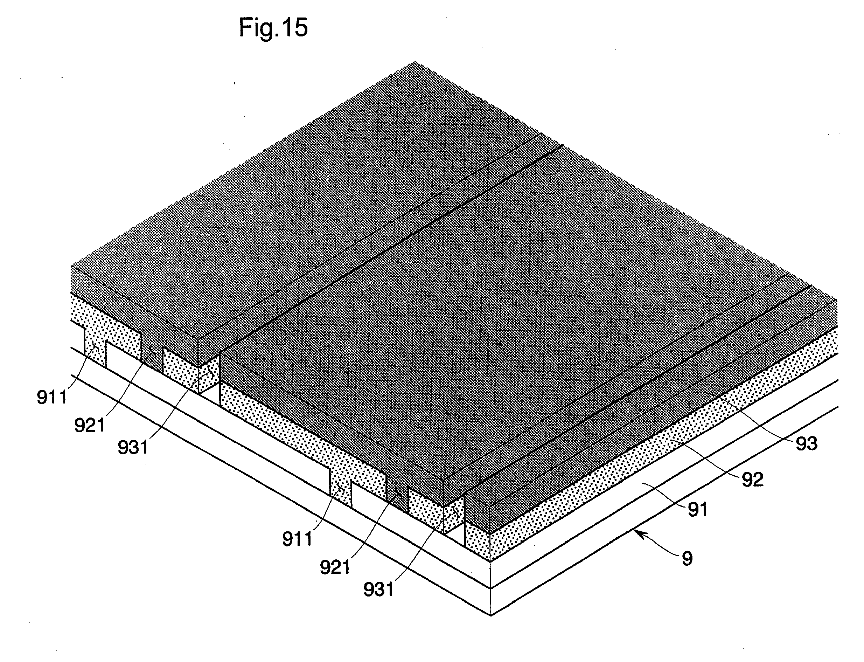

An embodiment of the present invention will be described with reference to the drawings. Firstly, an overview of laser patterning (in other words, abrasion processing) in a manufacturing process of a thin-film solar cell serving as one of uses of a laser beam machine 1 of the present embodiment will be described. As exemplified in Fig. 15, the thin-film solar cell is manufactured by forming a laminated film, that is, a transparent conductive film 91, an amorphous semiconductor film or a laminated film 92 of an amorphous semiconductor film and a microcrystal semiconductor film, and a metal film 93 on a transparent substrate 9. In a case of a CIGS solar cell as another type, a back surface electrode film 91 of Mo or the like, a photoelectric conversion layer 92 of CIGS or the like, and a transparent conductive film 93 of ZnO or the like are formed.

As an order of manufacturing, firstly, the transparent conductive film 91 is formed on the substrate 9, and a laser beam having wavelength of 1,064 nm is irradiated to this transparent conductive film 91 so as to remove this, and hence separation grooves 911 are formed. Next, the semiconductor film 92 is formed on the transparent conductive film 91, and a laser beam having wavelength of 532 nm is irradiated to this semiconductor film 92 so as to remove this, and hence separation grooves 921 are formed. The semiconductor film 92 comes into the separation grooves 911. Further, the metal film 93 is formed on the semiconductor film 92, the laser beam having the wavelength of 532 nm is irradiated to the semiconductor film 92 so as to remove the metal film 93 together with the semiconductor film 92, and hence separation grooves 931 are formed. The metal film 93 comes into the separation grooves 921. Through the above processes, a region between the separation grooves 931 and the separation grooves 911 where the separation grooves 921 are not placed functions as a photovoltaic element. In this connection, there is sometimes a case where an intermediate layer (not shown) is provided between the layers.

The laser beam machine 1 of the present embodiment is used in a manufacturing process of the thin-film solar cell so as to irradiate the laser beam to the transparent conductive film 91, the photoelectric conversion film 92, the back surface electrode film 93, and the like formed on a processed surface of the glass substrate 9, that is, an upper surface, and to perform patterning of the separation grooves 911, 921, 931, and the like.

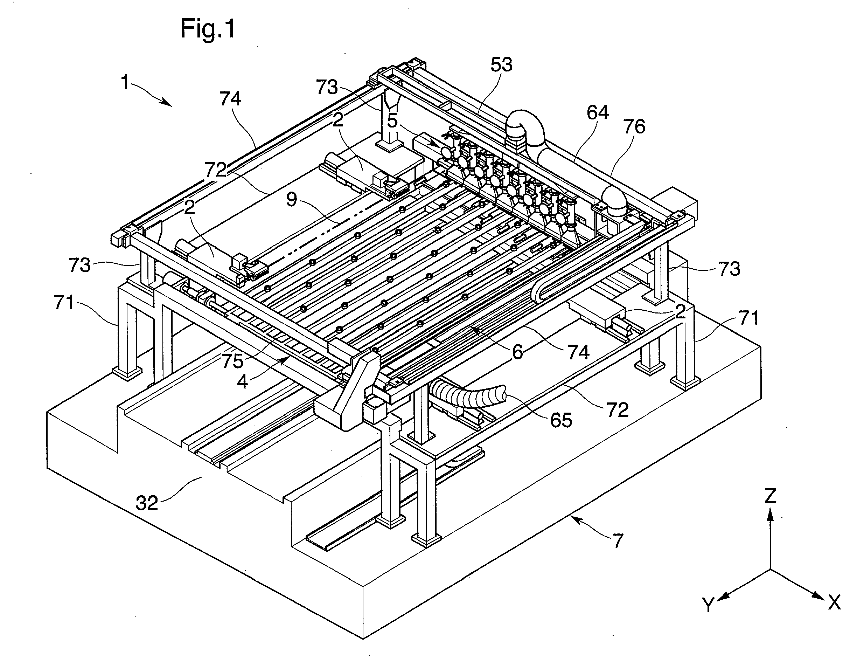

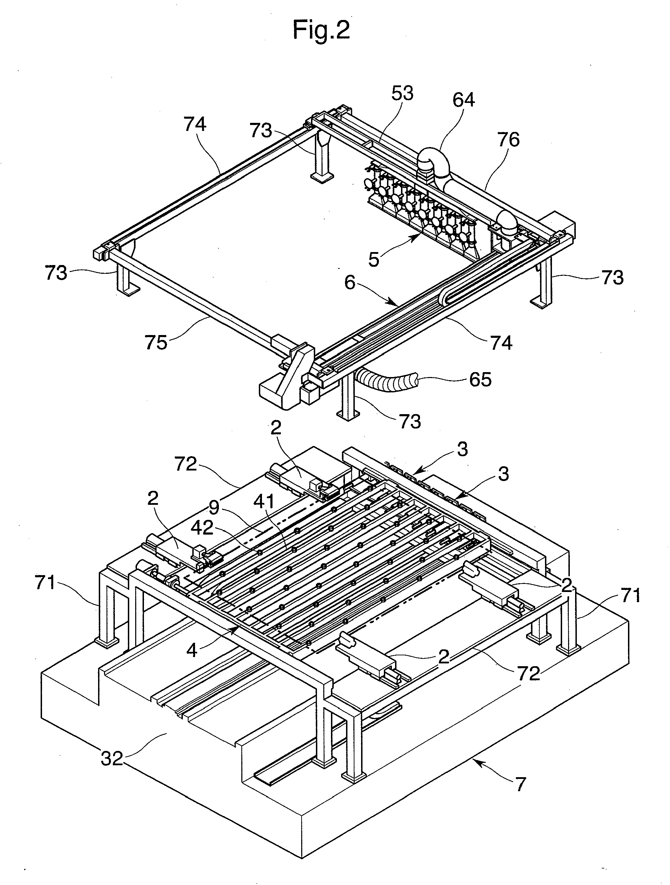

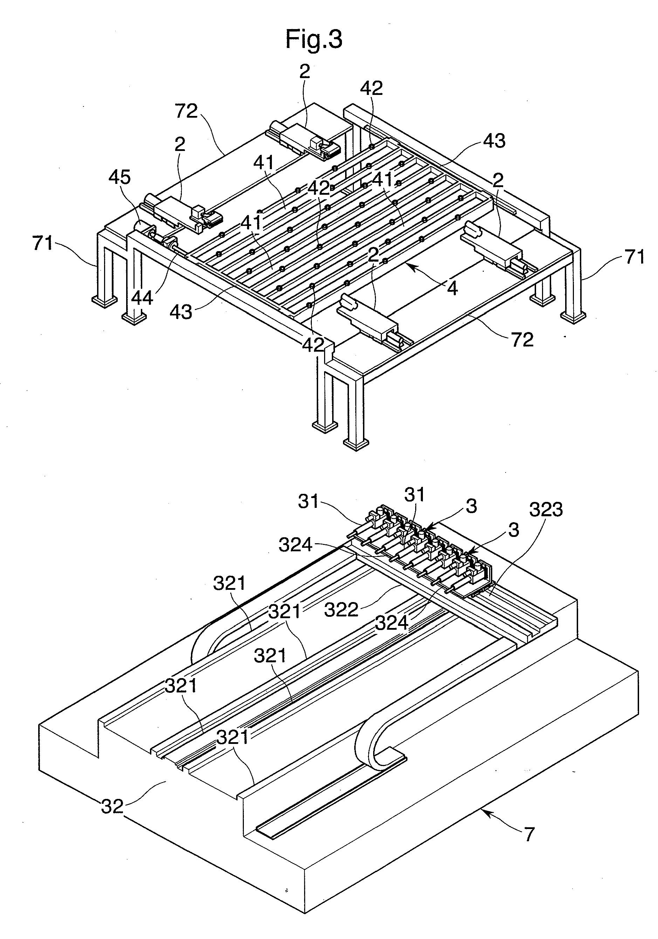

Hereinafter, for simplifying description, the direction in which processing nozzles 3 and a dust collection nozzle 5 are reciprocated so as to form the separation grooves 911, 921, 931 (Y axis direction) is defined as the front and rear direction, and the direction of pitch feed of the processing nozzles 3 and the dust collection nozzle 5 (X axis direction) is defined as the left and right direction. As shown in Figs. 1 to 4, the laser beam machine 1 of the present embodiment is provided with a main body including a base 7, a support mechanism 4, and retention mechanisms 2, the processing nozzles 3 arranged on the lower side of the support mechanism 4, and the dust collection nozzle 5 suspended on the upper side of the support mechanism 4.

The support mechanism 4 is to support the substrate 9 conveyed into the laser beam machine 1, and mainly serves as an underframe. The underframe 4 is held up at height with which the underframe is not brought into contact with the processing nozzles 3, a XY stage 32, and the like by a main body frame 71 fixed to the base 7. This underframe 4 is formed into a shape in which a plurality of opening windows 41 expanding in the front and rear direction and passing through in the up and down direction is arranged in the left and right direction. The number of the opening windows 41 is equal to the number of the processing nozzles 3. The laser beam emitted from the processing nozzles 3 passes through the opening windows 41. A large number of rolling bodies 42 capable of freely rotating are provided in peripheral parts of the opening windows 41 of the underframe 4 while being scattered in the front and rear and left and right directions. The rolling bodies 42 are for example so-called ball bearings. The conveyed substrate 9 is disposed on these rolling bodies 42.

The underframe 4 is movable in the left and right directions via rail mechanisms 43 provided in front and rear ends thereof. A screwing mechanism 44 for causing movement in the left and right direction of the underframe 4 is placed between the underframe 4 and the main body frame 71. The screwing mechanism 44 is driven by a pitch feed motor 45 so as to pitch-feed and move the underframe 4 in the left and right direction.

The retention mechanisms 2 are to retain the substrate 9 not to be moved at the time of laser beam machining, and mainly serve as retention pushing plates provided beside the support mechanism 4. The pairs of left and right retention pushing plates 2 are placed on the outer side of the underframe 4 at height positions where the retention pushing plates face an upper surface of (the rolling bodies 42 of) the underframe 4. The retention pushing plates 2 are attached onto left and right plates 72 fixed to the main body frame 71. These retention pushing plates 2 are driven by air cylinders, brought close or separated in the left and right direction, and abutted with side end surfaces of the substrate 9 so as to nip the substrate 9 from the left and right sides. It should be noted that in place of the retention pushing plates 2, or together with the retention pushing plates 2, clamps, suction cups, or the like may be adopted.

The processing nozzles 3 are supported by the XY stage 32. The XY stage 32 is provided with Y axis rails 321 extending in the front and rear direction, a X axis unit 322 guided by the Y axis rails 321 so as to travel in the front and rear direction and extend in the left and right direction, the X axis unit including a X axis rail 323 in an upper part thereof, and platform trucks 324 guided by the X axis rail 323 so as to pitch-feed and move in the left and right direction. A linear servo mover serves as a drive source for both the X axis unit 322 and the platform trucks 324. In the present embodiment, the plurality of platform trucks 324 is arranged in the X axis unit 322, and each of the processing nozzles 3 is provided in each of the platform trucks 324.

An optical fiber 31 for guiding the laser beam supplied from a laser oscillator is connected to each of the processing nozzles 3. The laser beam supplied from the laser oscillator (not shown) is introduced into the processing nozzles 3 through the optical fibers 31, and emitted vertically upward from emitting ends in upper parts of the nozzles via optical systems such as collective lenses in the processing nozzles 3.

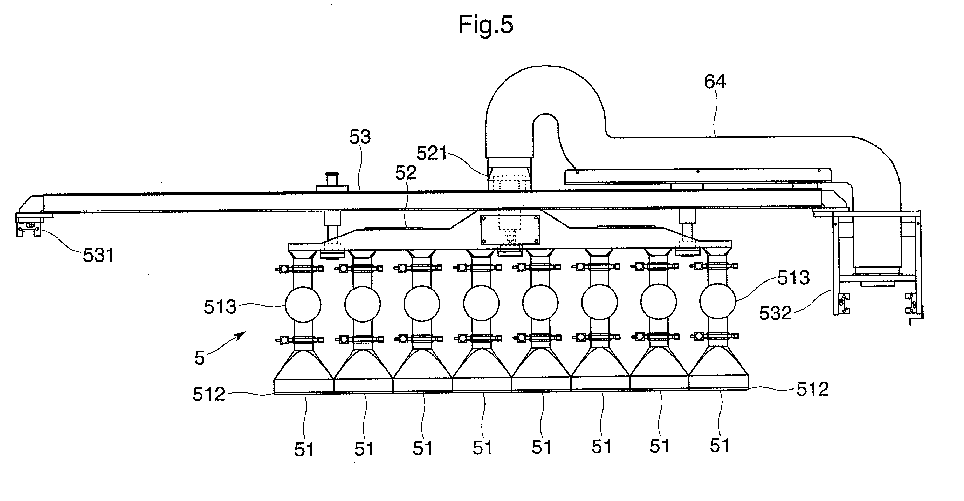

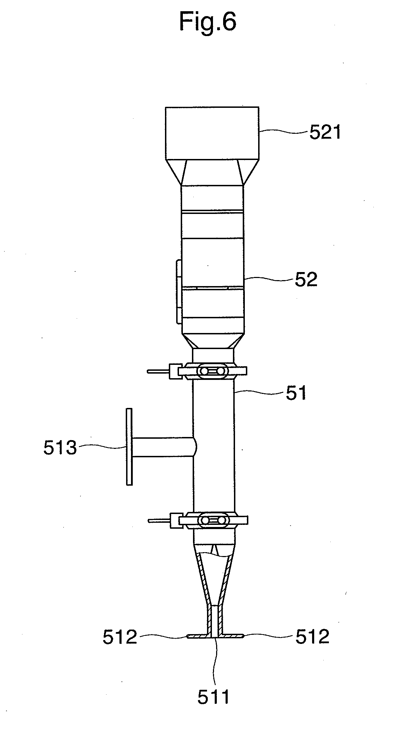

The dust collection nozzle 5 is provided so as to suction powder dust generated by the patterning of the thin films 91, 92, 93. As shown in Figs. 5 and 6, the dust collection nozzle 5 has a downward-opening suction port 511 placed in the vicinity of the processed surface of the substrate 9. In more detail, the dust collection nozzle 5 is formed by continuously connecting a plurality of nozzle members 51 in the left and right direction by welding or the like. Lower parts of the nozzle members 51 are spread in the left and right direction toward the lower side but gradually narrowed in the front and rear direction. In lower ends of the nozzle members 51, lips 512 bent so as to be away from each other protrude in the front and rear direction from lower ends of facing front and rear walls forming the suction port 511. The lips 512 perform an operation of generating an air stream flowing in the direction of the suction port 511 in a clearance between lower surfaces of the lips 512 and the processed surface of the substrate 9, and improve a powder dust suction performance. The nozzle members 51 aligning and continuing in the left and right direction form the thin and long suction port 511 expanding in the left and right direction as a whole. Size in the left and right direction of this suction port 511 as a whole is substantially equal to or larger than width of the substrate 9 serving as an object of processing.

An air damper (or a flow rate control valve) 513 is provided in the middle of each of the nozzle members 51. The air dampers 513 enable to manually adjust an air volume flowing inside the nozzle members 51. Upper parts of the nozzle members 51 are coupled to a single collecting pipe 52 extending in the left and right direction. A center part of the collecting pipe 52 serves as a connector 521 protruding upward. The connector 521 is a discharge port for the powder dust, and the dust collection nozzle is connected to a dust collection machine (not shown) via this connector 521. An interior of the collecting pipe 52, particularly inner size in the up and down direction is largest in the center part, smaller in adjacent left and right parts, and smallest in both left and right ends. This is to equalize a flow rate or a suction pressure volume of a suction air stream generated in the vicinity of the suction port 511 of the nozzle members 51. On the same point, each of the air dampers 513 is provided in each of the nozzle members 51.

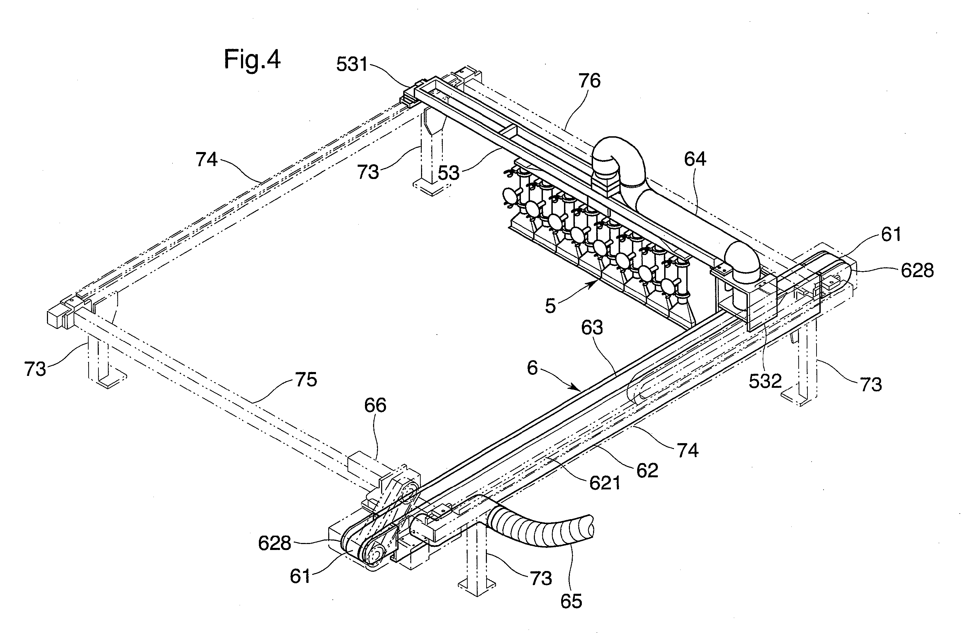

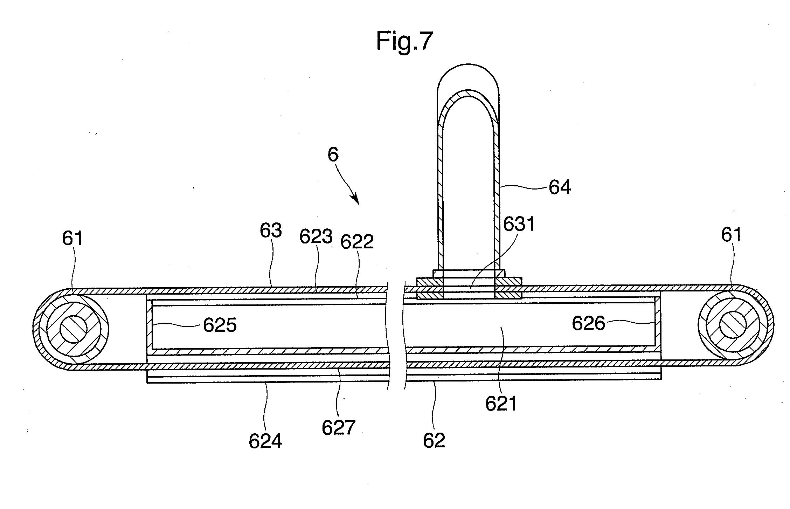

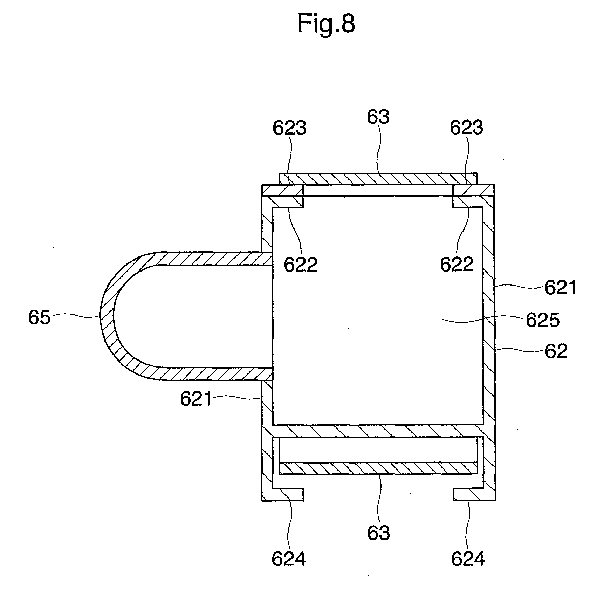

A dust collection connection mechanism 6 is placed between the dust collection nozzle 5 and the dust collection machine. As shown in Figs. 4, 7, and 8, the dust collection connection mechanism 6 is provided with a pair of rollers 61 separated along the front and rear direction, a chamber 62 arranged between these rollers 61, the chamber extending along the front and rear direction and having an opening expanding in the same direction, a belt 63 looped over the rollers 61, the belt for closing the opening of the chamber 62 and having a through hole 631 formed in part thereof, and a duct 64 with one end joined to the connector 521 of the dust collection nozzle 5 and the other end joined to the through hole 631 of the belt 63.

In the present embodiment, the chamber 62 is an upward-opening long box member, and opens upward. Upper ends 622 of left and right side walls 621 of the chamber 62 are bent so as to come close to each other and extend inward, and slightly narrow opening width of the chamber 62. Slipping members 623 are installed onto upper surfaces of these bent pieces 622. The slipping members 623 are for example thin plate materials made of hard resin, and play a role of reducing friction with the belt 63. The front roller 61 is placed on the front side of a front wall 625 of the chamber 62, and the rear roller 61 is placed on the rear side of a rear wall 626 of the chamber 62. Bearings 628 for rotatably and axially supporting these rollers 61 are fixed to front and rear ends of the chamber 62. The left and right side walls 621 of the chamber 62 are suspended downward exceeding a bottom wall 627 of the chamber 62, and lower ends 624 thereof are also bent so as to come close to each other and extend inward.

The belt 63 is for example a steel belt, looped over the front and rear rollers 61 so as to serve as an endless track wrapping the chamber 62. In an upper run of this endless track, the belt 63 is abutted with the slipping members 623 so as to block the opening of the chamber 62 from the upper side. In a lower run of the endless track, the belt 63 passes through a space between the bottom wall 627 of the chamber 62 and the lower bent pieces 624. The through hole 631 is formed in the upper run of the endless track. The chamber 62, the rollers 61, and the belt 63 are arranged on the outer side of the underframe 4.

A discharge port for the powder dust is provided in a predetermined part of the chamber 62 (outer side wall 621 in a front part of the chamber 62 in the example of the figure), a hose 65 is connected to this discharge port, and the hose 65 is connected to the dust collection machine. Therefore, the powder dust suctioned from the suction port 511 of the dust collection nozzle 5 passes through the duct 64 and an interior of the chamber 62, and reaches the dust collection machine via the hose 65. In this connection, the interior of the chamber 62 is turned into negative pressure by suctioning of the dust collection machine, and the belt 63 clings to the upper bent pieces 622 of the chamber 62 so as to favorably close the opening.

In the present embodiment, the dust collection nozzle 5 and the duct 64 is capable of reciprocating in the front and rear direction following the processing nozzles 3. A structure for suspending the dust collection nozzle 5 and the like includes elements of supports 73 standing from four corners of the plates 72, and side beams 74, a front beam 75, and a rear beam 76 connecting upper ends of the supports 73. A front part of the above chamber 62 is fixed to the front beam 75, and a rear part of the chamber is fixed to the rear beam 76. The dust collection nozzle 5 and the duct 64 are supported on a bridging frame 53 extending in the left and right direction. A left end of the bridging frame 53 is supported by a conveyance rail provided in the left side beam 74 via a platform truck 531, and a right end of the bridging frame 53 is also supported by a conveyance rail provided in the chamber 62 via a platform truck 532. Thereby, the bridging frame 53 is capable of traveling in the front and rear direction along the left side beam 74 and the chamber 62. The right end of the bridging frame 53 is attached to a part in the vicinity of the through hole 631 of the belt 63 together with the duct 64.

In the present embodiment, the belt 63 also serves as a travel drive mechanism of the bridging frame 53, and by extension, of the dust collection nozzle 5. That is, one of the rollers 61 over which the belt 63 is looped (front roller 61 in the example of the figure) is driven and rotated by a servomotor 66. The belt 63 is driven by rotation of the rollers 61 and moved in the front and rear direction. The bridging frame 53 and the like are reciprocated in the front and rear direction by this movement of the belt 63. However, it can be thought that the left or right platform truck 531, 532 of the bridging frame 53 is a linear motor mover, and the dust collection nozzle 5 is driven to travel with the platform truck 531, 532 as a drive source.

Upon executing the laser beam machining, firstly, the substrate 9 with the processed surface on which the thin films 91, 92, 93 are formed up is conveyed in from the front side. That is, while clamping side edges of the substrate 9 by a conveying clamper (not shown), a conveyance unit (not shown) is driven. Thus, the substrate 9 is fed onto the underframe 4 and disposed on the underframe 4. Next, the substrate 9 is nipped from both the sides by pushing the retention pushing plates 2 to both the side end surfaces of the substrate 9, so that the substrate 9 is retained relative to the base 7.

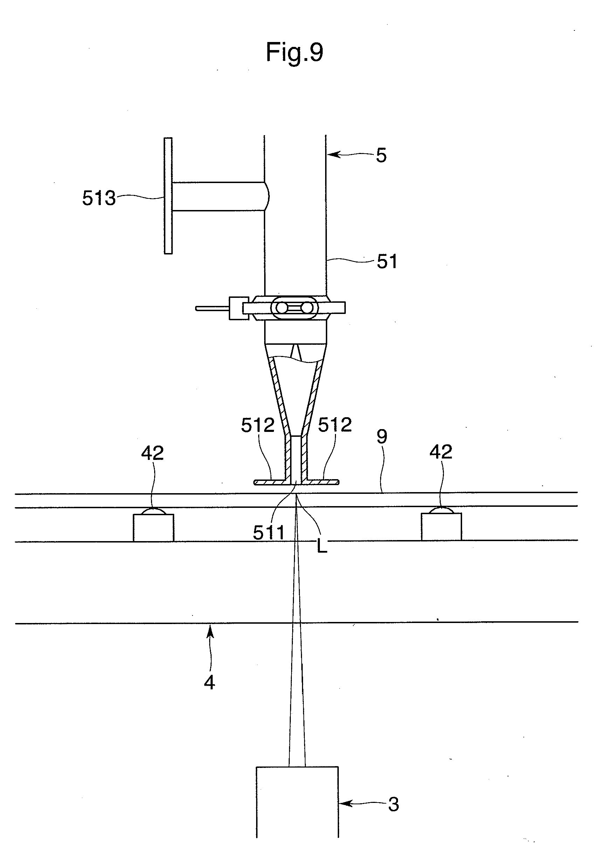

After that, the processing nozzles 3 are moved to a desired processed part, and the laser beam is emitted upward, made pass through the substrate 9, and irradiated to the thin films 91, 92, 93 on the processed surface. Specifically, while the X axis unit 322 travels in the front and rear direction, a pulse laser beam is continuously irradiated, and the separation grooves 911, 921, 931 extending in the front and rear direction are formed in the thin films 91, 92, 93. At the same time, by the bridging frame 53 traveling in the front and rear direction, the dust collection nozzle 5 follows the X axis unit 322, and as shown in Fig. 9, the suction port 511 is always positioned immediately above a laser beam irradiation part L. Then, the dust collection machine is operated, so as to collect the powder dust generated from the irradiation part L.

The platform trucks 324 provided with the processing nozzles 3 are pitch-fed and moved in the left and right direction, so that formation positions of the separation grooves 911, 921, 931 are changed. At the same time, the underframe 4 is also moved in the left and right direction in conjunction with the platform trucks 324 so that a laser beam axis is not brought into contact with the underframe 4. At this time, the underframe 4 supporting the substrate 9 is displaced relative to the substrate 9. However, since the rolling bodies 42 are placed between a lower surface of the substrate 9 and the upper surface of the underframe 4 and rotated, the movement of the underframe 4 is not prevented. It should be noted that pitch feed of the processing nozzles 3 by the linear motor platform trucks 324 is instantaneous, whereas pitch feed of the underframe 4 by the screwing mechanism 44 is movement at substantially constant velocity even during the processing nozzles 3 traveling, but the laser beam axis is always in the opening windows 41.

In this connection, while the platform trucks 324 and the underframe 4 are moved together in the left and right direction, the pulse laser beam is continuously irradiated, and grooves extending in the left and right direction can be formed in the thin films 91, 92, 93.

When the laser beam machining is completed, the substrate 9 is conveyed out to the rear side. That is, retention of the substrate 9 by the retention pushing plates 2 is cancelled, and while clamping the side edges of the substrate 9 by the conveying clamper, the conveyance unit is driven. Thus, the substrate 9 is fed out from above the underframe 4.

According to the present embodiment, the laser beam machine 1 includes the main body supporting the substrate 9 with the processed surface to which the laser beam machining is performed up, the processing nozzles 3 provided on the lower side of the substrate 9 so as to travel in the predetermined traveling direction, the processing nozzles for emitting the laser beam upward, making the laser beam pass through the substrate 9, and irradiating the laser beam to the processed surface, and the dust collection nozzle 5 provided on the upper side of the substrate 9 so as to travel in the traveling direction following the processing nozzles 3, the dust collection nozzle being always placed immediately above the laser beam irradiation part L of the processed surface, the dust collection nozzle for suctioning the powder dust generated from this irradiation part L and scattered upward. Thus, there is no need for reciprocating the substrate 9 back and forth at the time of the laser beam machining, so that a required area of the machine 1 can be reduced. Furthermore, the substrate 9 can be conveyed into and out from the laser beam machine 1 while keeping the processed surface up. Thus, there is no need for an inversion machine.

Moreover, by the dust collection nozzle 5 traveling following the processing nozzles 3, while narrowing inner size of the suction port 511 of the dust collection nozzle 5, the suction port 511 is always positioned immediately above the laser beam irradiation part L during processing. Thus, the powder dust scattered upward upon receiving irradiation of the laser beam can be quickly collected via the dust collection nozzle 5, and a suction flow rate in the vicinity of the laser beam irradiation part L is effectively increased. Thus, the dust of large mass can be also reliably suctioned.

The dust collection nozzle 5 has the downward suction port 511 provided in the vicinity of the processed surface of the substrate 9 and opened immediately above the irradiation part L, and this suction port 511 is formed into a long and thin hole expanding in the direction crossing the traveling direction. Thus, size in the front and rear direction of the suction port 511 can be narrowed down, so that improvement of the powder dust suction performance is encouraged.

Further, the lips 512 bent so as to be away from each other protrude from the lower ends of the front and rear walls forming the suction port 511 and facing in the traveling direction in the dust collection nozzle 5. Thus, the air stream flowing in the direction of the suction port 511 can be generated in the clearance between the lower surfaces of these lips 512 and the processed surface of the substrate 9, so that powder dust suctioning efficiency is more improved.

The laser beam machine further includes the dust collection connection mechanism 6 placed between the dust collection nozzle 5 and the dust collection machine, wherein the dust collection connection mechanism 6 includes the pair of rollers 61 separated along the traveling direction, the chamber 62 arranged between the rollers 61, the chamber extending along the traveling direction and having the opening expanding in the same direction, the belt 63 looped over the rollers 61, the belt for closing the opening of the chamber 62 and having the through hole 631 formed in part thereof, and the duct 64 with the one end joined to the dust collection nozzle 5 and the other end joined to the through hole 631, and dust collection is performed via the dust collection nozzle 5, the duct 64, and the chamber 62 by connecting the dust collection machine to the chamber 62. Thus, the belt 63 and the through hole 631 can be displaced in conjunction with travel of the dust collection nozzle 5. That is, without deformation of the duct 64 connecting the dust collection nozzle 5 and the through hole 631, the dust collection nozzle 5 can be driven to travel. Therefore, such a disadvantage that the duct 64 is broken due to fatigue caused by reciprocating travel of the dust collection nozzle 5 can be prevented.

The slipping members 623 for reducing the friction with the belt 63 are installed in an opening edge of the chamber 62. Thus, abrasion of the belt 63 and/or the chamber 62 can be suppressed.

The processing nozzles 3 are also movable in the pitch feed direction crossing the traveling direction. Thus, a substantially entire surface of the substrate 9 can be processed through the pitch feed of the processing nozzles 3.

The main body includes the retention mechanisms 2 for retaining the substrate 9 not to be moved, and the support mechanism 4 relatively movable in the pitch feed direction relative to the substrate 9 while supporting the substrate 9 from the lower side. Since the processing can be performed without moving the substrate 9 at the time of the laser beam machining, processing precision can be effectively enhanced. Since the substrate 9 is not reciprocated back and forth, the abrasion of the rolling bodies 42 is not easily caused. Further, since the substrate 9 can be supported at a plurality of points (of the rolling bodies 42) spread on a plane, warp due to self-weight of the substrate 9 can be suppressed.

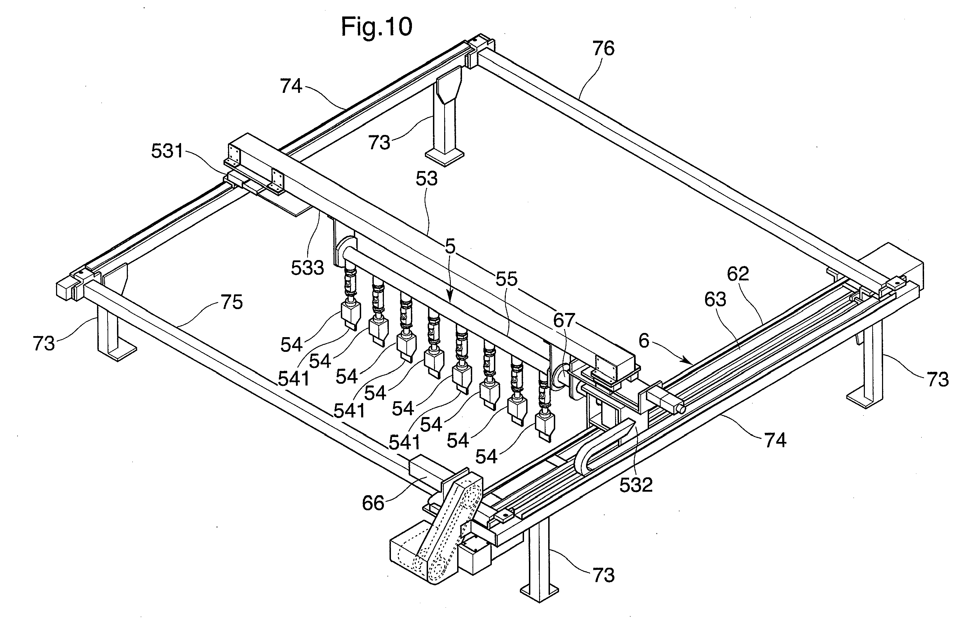

It should be noted that the present invention is not limited to the embodiment described above. The dust collection nozzle in the above embodiment is not moved in the left and right direction. However, the dust collection nozzle may be pitch-fed in the left and right direction. In a modified example shown in Fig. 10, size in the left and right direction of suction ports 541 in lower parts of nozzle members 54 forming the dust collection nozzle 5 is reduced. Thereby, the suction flow rate can be more increased by reducing opening areas of the suction ports 541, whereas gaps are generated between the suction ports 541 of the nozzle members 54. Thus, there is also a need for moving this dust collection nozzle 5 in the left and right direction. In the present modified example, a rail mechanism 533 is placed between the dust collection nozzle 5 and the bridging frame 53 supporting this, so that the dust collection nozzle 5 is movable in the left and right direction. In addition, a screwing mechanism 534 for causing movement in the left and right direction of this dust collection nozzle 5 is additionally provided. The screwing mechanism 534 is driven by a pitch feed motor so as to pitch-feed and move the dust collection nozzle 5 in the left and right direction. A duct 67 for feeding the powder dust suctioned via the nozzle members 54 and a collecting pipe 55 to the chamber 62 has a structure capable of extending and contracting in the left and right direction, such as a telescopic structure. The number of the nozzle members 54 is equal to the number of the processing nozzles 3. According to the present modified example, the suction ports 541 can be always positioned immediately above the laser beam irradiation part L displaced in the left and right direction in accordance with the pitch feed of the processing nozzles 3.

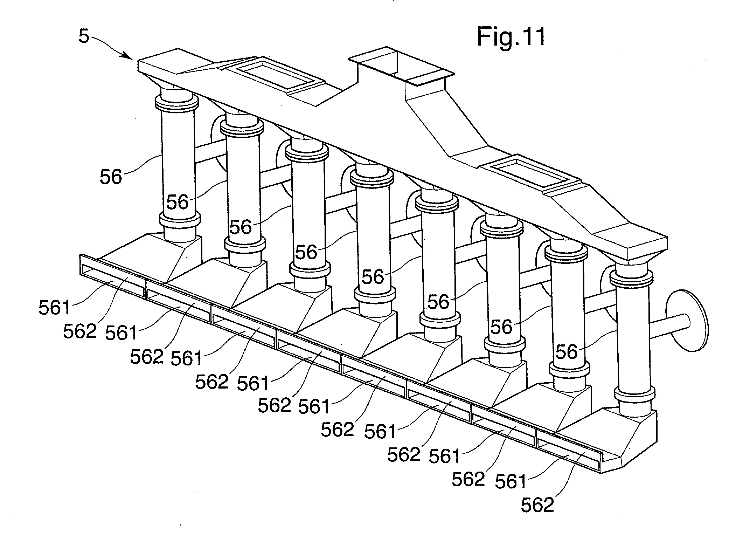

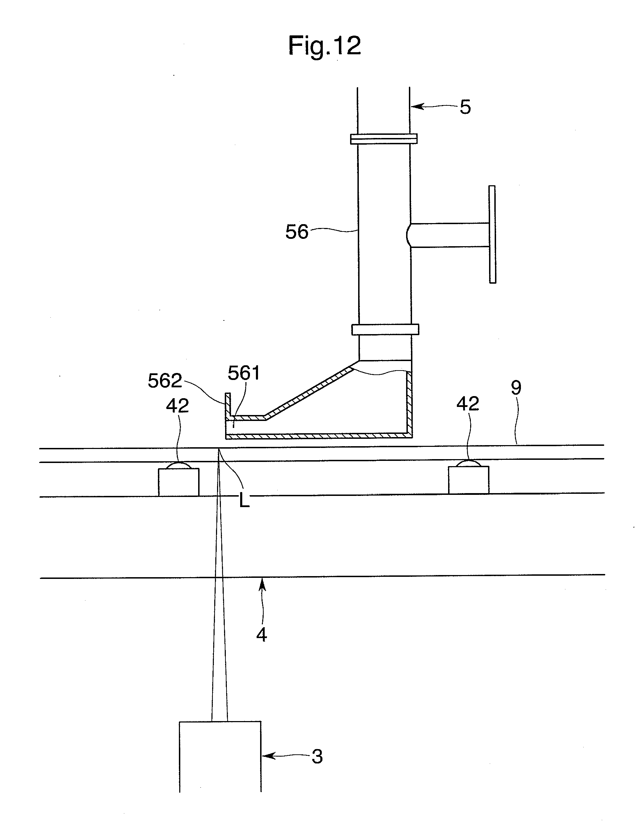

The suction port of the dust collection nozzle in the above embodiment opens downward. However, the suction port may open forward or rearward. In other words, the suction port may be directed in the traveling direction of the processing nozzles and the dust collection nozzle. In a modified example shown in Figs. 11 and 12, suction ports 561 in lower parts of nozzle members 56 are directed forward. Bottom walls forming the suction ports 561 are placed in the vicinity of the processed surface of the substrate 9, and face the processed surface in substantially parallel. Upper walls facing the bottom walls are closest to the bottom walls at front ends thereof, that is, opening edges of the suction ports 561, and inclined so as to be gradually away from the bottom walls toward the rear side. By these bottom walls and the upper walls, size in the up and down direction of the suction ports 561 is narrowed. Lips 562 bent vertically upward protrude from front ends of the upper walls. As shown in Fig. 12, in the present modified example, the suction ports 561 of the dust collection nozzle 5 are always positioned in the vicinity (immediately behind) of the laser beam irradiation part L, so that the powder dust generated from the irradiation part L is collected. The present modified example is effective in a case where mass of dust, particles, vapor, or the like generated at the time of the processing is relatively light.

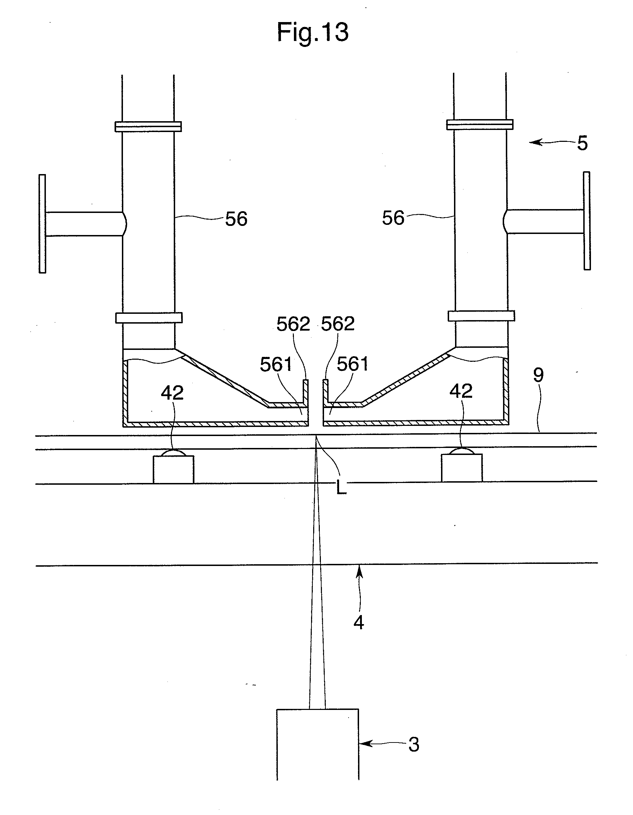

Further, as shown in Fig. 13, the nozzle members 56 shown in the above modified example may be arranged face-to-face in the front and rear direction, so as to form the dust collection nozzle 5. In such a way, a rapid air stream flowing in the direction of the suction ports 561 can be generated in a clearance between lower surfaces of the bottom walls of the suction ports 561 and the processed surface of the substrate 9. Thus, the powder dust suction performance is effectively improved.

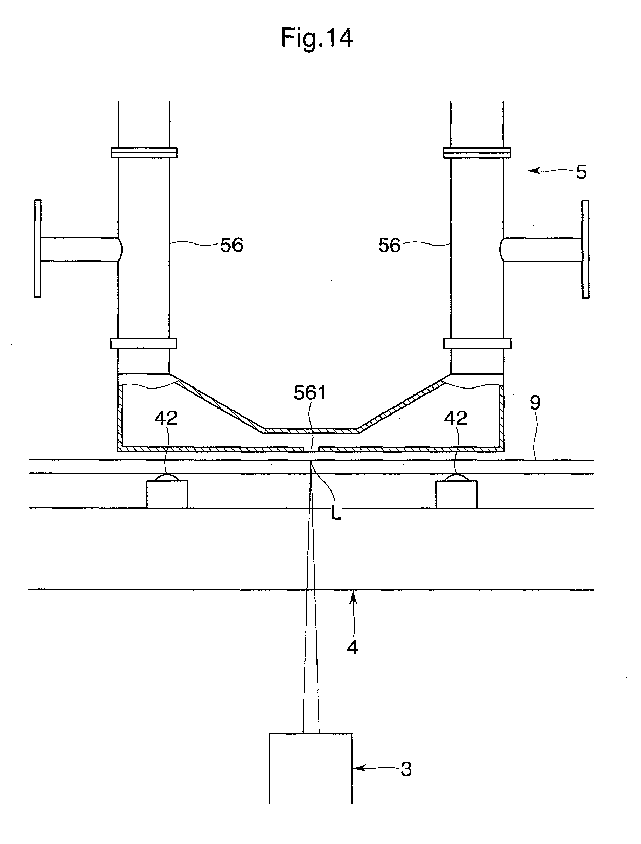

As shown in Fig. 14, the nozzle members 56 arranged face-to-face in the front and rear direction may be completely integrated. The suction ports 561 of the dust collection nozzle 5 in the present modified example are formed into a slit shape opening downward and expanding in the left and right direction, and positioned immediately above the laser beam irradiation part L.

The dust collection connection mechanism placed between the dust collection nozzle and the dust collection machine is not limited to the above embodiment. For example, the duct is formed by a plurality of members, and both the members are coupled so as to relatively rotate and communicate with each other via a pivot. Further, one end of this duct and the dust collection nozzle, and the other end of this duct and a predetermined part on the side of the main body are coupled so as to relatively rotate and communicate with each other via a similar pivot. A hose continuing to the dust collection machine is attached to the predetermined part on the side of the main body. The travel drive mechanism for reciprocating the dust collection nozzle is separately installed. In such a way, reciprocation in the front and rear direction of the dust collection nozzle can be permitted through oscillation on the pivots of the members forming the duct.

In the above embodiment, the laser beam supplied from the laser oscillator is guided to the processing nozzles via the optical fibers. However, the laser beam may be guided to the processing nozzles with using not the optical fibers but a mirror, a beam splitter, or the like.

The rolling bodies provided in the support mechanism are not limited to the ball bearings but may be rollers, an endless track, or the like.

A rotation device for horizontally rotating the substrate on the support mechanism may be separately arranged. Thus, without performing a pitch feed operation of the processing nozzles and the support mechanism, the grooves extending crosswise and lengthwise can be formed on (the thin films formed in) the processed surface of the substrate.

Instead of providing the rolling bodies in the support mechanism, a levitation device for blowing out the air upward, or the like may be provided. For example, the levitation device can be installed in a part of the support mechanism where the opening windows are not provided, and supported in a state that the substrate is levitated from the support mechanism 4 by the air.

Specific configurations of the parts can be variously modified within a scope not departing from the gist of the present invention.

### INDUSTRIAL APPLICABILITY

The present invention can be utilized as a machine for performing laser scribing, patterning, and the like to a thin film in a manufacturing process of for example, a solar panel, an organic EL display, and a plasma display.

### DESCRIPTION OF REFERENCE SIGNS

1: Laser beam machine
2: Retention mechanism
3: Processing nozzle
4: Support mechanism
5: Dust collection nozzle
6: Dust collection connection mechanism
9: Substrate
L: Laser beam irradiation part
X: Pitch feed direction of processing nozzle and dust collection nozzle
Y: Traveling direction of processing nozzle and dust collection nozzle

## Claims

1. A laser beam machine comprising:
a main body supporting a substrate with a processed surface to which laser beam machining is performed up;
a processing nozzle provided on the lower side of the substrate so as to travel in the predetermined traveling direction, the processing nozzle for emitting a laser beam upward, making the laser beam pass through the substrate, and irradiating the laser beam to the processed surface; and
a dust collection nozzle provided on the upper side of the substrate so as to travel in the traveling direction following the processing nozzle, the dust collection nozzle being always placed immediately above or in the vicinity of a laser beam irradiation part of the processed surface, the dust collection nozzle for suctioning powder dust generated from the irradiation part and scattered upward.

2. The laser beam machine according to claim 1, wherein the dust collection nozzle has a downward suction port provided in the vicinity of the processed surface of the substrate and opened immediately above the irradiation part, and the suction port is a long and thin hole expanding in the direction crossing the traveling direction.

3. The laser beam machine according to claim 2, wherein lips bent so as to be away from each other protrude from lower ends of front and rear walls forming the suction port and facing in the traveling direction in the dust collection nozzle.

4. The laser beam machine according to claim 1, wherein the dust collection nozzle has a suction port in the traveling direction provided in the vicinity of the processed surface of the substrate and opened in the vicinity of the irradiation part, and the suction port is a long and thin hole expanding in the direction crossing the traveling direction.

5. The laser beam machine according to claim 1, 2, 3, or 4, further comprising: a dust collection connection mechanism placed between the dust collection nozzle and a dust collection machine, wherein
the dust collection connection mechanism includes
a pair of rollers separated along the traveling direction,
a chamber arranged between the rollers, the chamber extending along the traveling direction and having an opening expanding in the same direction,
a belt looped over the rollers, the belt for closing the opening of the chamber and having a through hole formed in part thereof, and
a duct with one end joined to the dust collection nozzle and the other end joined to the through hole, and
dust collection is performed via the dust collection nozzle, the duct, and the chamber by connecting the dust collection machine to the chamber.

6. The laser beam machine according to claim 5, wherein a slipping member for reducing friction with the belt is installed in an opening edge of the chamber.

7. The laser beam machine according to claim 1, 2, 3, 4, 5, or 6, wherein the processing nozzle is also movable in the pitch feed direction crossing the traveling direction.

8. The laser beam machine according to claim 7, wherein the main body includes a retention mechanism for retaining the substrate not to be moved, and a support mechanism relatively movable in the pitch feed direction relative to the substrate while supporting the substrate from the lower side.
